# EUROPEAN PATENT APPLICATION

(11) **EP 4 712 739 A1**
(43) Date of publication of application: **18.03.2026**
(21) Application number: 24905350.5
(22) Date of filing: 01.04.2024
(51) Int. Cl.: H10F 77/14, H10F 77/20, H10F 77/30, H10F 19/90

(54) **BACK-CONTACT SOLAR CELL, BATTERY ASSEMBLY AND PHOTOVOLTAIC SYSTEM**

(30) Priority: 22.12.2023 CN 202323525988 U; 22.12.2023 CN 202311786045
(71) Applicant: Zhejiang Aiko Solar Energy Technology Co., Ltd., Yiwu, Jinhua Zhejiang 322000 (CN); Tianjin Aiko Solar Energy Technology Co., Ltd., Tianjin 300400 (CN); Zhuhai Fushan Aiko Solar Energy Technology Co., Ltd., FushanIndustrial Park, Doumen District Zhuhai Guangdong 519000 (CN); Guangdong Aiko Solar Energy Technology Co., Ltd., Foshan, Guangdong 528000 (CN); Shenzhen Aiko Digital Energy Technology Co., Ltd., Shenzhen, Guangdong 518000 (CN)
(72) Inventor: WANG, Yongqian, Jinhua, Zhejiang 322000 (CN); ZHANG, jianjun, Jinhua, Zhejiang 322000 (CN); YANG, Xinqiang, Jinhua, Zhejiang 322000 (CN); CHEN, Gang, Jinhua, Zhejiang 322000 (CN)
(74) Representative: EP&C
(86) International application number: PCT/CN2024/085296
(87) International publication number: WO 2025/129846

(57) **Abstract**

The present disclosure is applicable to the technical field of solar cells, and provides a back-contact solar cell (100), a battery assembly (200), and a photovoltaic system (1000). In the back-contact solar cell (100), several first polarity doped layers (20) and several second polarity doped layers (30) are disposed on a back surface (11) of a silicon substrate (10) in a stacked manner, are sequentially and alternately arranged at intervals in a first direction and extend in a second direction. Back-surface passivation film layers (40) are disposed on the first polarity doped layers (20) and the second polarity doped layers (30) in the stacked manner, first fine gates (50) are correspondingly disposed on the first polarity doped layers (20), and second fine gates (60) are correspondingly disposed on the second polarity doped layers (30). In the second direction, several third polarity doped layers (70) arranged at intervals are disposed below the first fine gates (50), the first fine gates (50) are made of a burn-through paste, and a polarity of the third polarity doped layers (70) is opposite to a polarity of the first polarity doped layers (20). In the second direction, at positions corresponding to the third polarity doped layers (70), the first fine gates (50) burn through the back-surface passivation film layers (40) to make contact with the third polarity doped layers (70), and between two adjacent third polarity doped layers (70), the first fine gates (50) burn through the back-surface passivation film layers (40) to make contact with the first polarity doped layers (20). The third polarity doped layers (70) are obtained by partially removing clad layers formed on the first polarity doped layers (20) during a process of forming the second polarity doped layers (30).

## Description

### Priority Information

The present disclosure claims the priorities and benefits of Patent Disclosure 202311786045.1 and 202323525988.7, filed in the China National Intellectual Property Administration on December 22, 2023, and the entire contents of which are herein incorporated by reference.

### Technical Field

The present disclosure relates to the technical field of solar cell, and in particular to a back-contact solar cell, a battery assembly, and a photovoltaic system.

### Background

Power generation of solar cells is a sustainable and clean energy source that can convert sunlight into electrical energy by using the photovoltaic effect of semiconductor p-n junctions.

Among solar cells, a back-contact solar cell is a cell in which an emitter and a base contact electrode are both placed on a back surface (a non-light-receiving surface) of the cell, and a light-receiving surface of the cell is not shielded by any metal electrode, thereby effectively increasing the short-circuit current of the cell. With regard to the back-contact solar cell, P-type doped layers are usually prepared on the back surface, then slotting is performed and N-type doped layers are formed, slotting is performed again to separate the P-type doped layers from the N-type doped layers, and then fine gates and main gates are prepared.

In the related art, all the fine gates of the back-contact cell usually penetrate through passivation film layers to make contact with the doped layers, and in this case, the contact area between the fine gates and the doped layers is relatively large, thus easily leading to relatively large composite current in a metal region and relatively low conversion efficiency.

### Summary

The present disclosure provides a back-contact solar cell, a battery assembly, and a photovoltaic system.

The present disclosure is implemented in such a way that the back-contact solar cell in an embodiment of the present disclosure includes:
a silicon substrate;
several first polarity doped layers and several second polarity doped layers, which are disposed on a back surface of the silicon substrate in a stacked manner, wherein the first polarity doped layer and the second polarity doped layer are sequentially and alternately arranged at intervals in a first direction and extend in a second direction, and the second direction intersects with the first direction;
back-surface passivation film layers, which are disposed on the first polarity doped layers and the second polarity doped layers in the stacked manner; and
several first fine gates and several second fine gates, wherein the first fine gates are correspondingly disposed on the first polarity doped layers and are configured to collecting current of the first polarity doped layers, and the second fine gates are correspondingly disposed on the second polarity doped layers and are configured to collecting current of the second polarity doped layers;
in the second direction, several third polarity doped layers arranged at intervals are disposed below the first fine gates, the third polarity doped layers are located between the back-surface passivation film layers and the first polarity doped layers, the first fine gates are made of a burn-through paste, and a polarity of the third polarity doped layers is opposite to a polarity of the first polarity doped layers;
in the second direction, at positions corresponding to the third polarity doped layers, the first fine gates burn through the back-surface passivation film layers to make contact with the third polarity doped layers, between two adjacent third polarity doped layers, the first fine gates burn through the back-surface passivation film layers to make contact with the first polarity doped layers, and the second fine gates at least partially penetrate through the back-surface passivation film layers to make contact with the second polarity doped layers; and
the third polarity doped layers are obtained by partially removing clad layers formed on the first polarity doped layers during a process of forming the second polarity doped layers.

Further, in the second direction, a ratio of a contact length between the first fine gate and the first polarity doped layer to a total length of the first fine gate is 30% to 80%.

Further, in the second direction, the ratio of the contact length between the first fine gate and the first polarity doped layer to the total length of the first fine gate is 40% to 60%.

Further, insulating isolation layers are further disposed between the third polarity doped layers and the first polarity doped layers, and the insulating isolation layers are also obtained by partially removing the clad layers formed on the first polarity doped layers during the process of forming the second polarity doped layers.

Further, in the first direction, a width of the third polarity doped layer is greater than or equal to a width of the first fine gate.

Further, the first polarity doped layer is a P-type doped layer, and the second polarity doped layer and the third polarity doped layer are both N-type doped layers.

Further, a bonding tensile force between the third polarity doped layer and the back-surface passivation film layer is greater than a bonding tensile force between the first polarity doped layer and the back-surface passivation film layer.

Further, the back-contact solar cell further includes welding spots electrically connected with the first fine gates, and the welding spots are disposed on the back-surface passivation film layers and are at least partially located above the third polarity doped layers.

Further, a projection area of the third polarity doped layer on the silicon substrate is greater than or equal to a projection area of the welding spot on the silicon substrate, and the welding spot is completely located in a projection region of the third polarity doped layer.

Further, in the second direction, at positions corresponding to the second fine gates, several barrier layers arranged at intervals are disposed between the second polarity doped layers and the back-surface passivation film layers, and the second fine gates are also made of the burn-through paste; and
at positions corresponding to the barrier layers, the second fine gates burn through the back-surface passivation film layers to make contact with the barrier layers, between two adjacent barrier layers, the second fine gates burn through the back-surface passivation film layers to make contact with the second polarity doped layers, and the barrier layers include phosphosilicate glass layers or borosilicate glass layers.

The present disclosure further provides a battery assembly, including several back-contact solar cells mentioned above.

The present disclosure further provides a photovoltaic system, including the battery assembly mentioned above.

Additional aspects and advantages of the present disclosure will be given in part in the following description, become apparent in part from the following description, or be learned from the practice of the present disclosure.

### Brief Description of the Drawings

Fig. 1 is a schematic diagram of modules of a photovoltaic system provided in an embodiment of the present disclosure;
Fig. 2 is a schematic diagram of a module of a battery assembly provided in an embodiment of the present disclosure;
Fig. 3 is a schematic diagram of a planar structure of a back-contact solar cell provided in an embodiment of the present disclosure;
Fig. 4 is a schematic diagram of a section of the back-contact solar cell in Fig. 2 along a line IV-IV;
Fig. 5 is a schematic diagram of a section of the back-contact solar cell in Fig. 2 along a line V-V;
Fig. 6 is a schematic diagram of another section of the back-contact solar cell in Fig. 2 along the line IV-IV;
Fig. 7 is a schematic diagram of another planar structure of a back-contact solar cell provided in an embodiment of the present disclosure;
Fig. 8 is a schematic diagram of a section of the back-contact solar cell in Fig. 7 along a line VIII-VIII; and
Fig. 9 is a schematic diagram of a section of the back-contact solar cell in Fig. 7 along a line IX-IX.

Description of Main Element Symbols:
photovoltaic system 1000, battery assembly 200, back-contact solar cell 100, silicon substrate 10, back surface 11, first polarity doped layer 20, second polarity doped layer 30, back-surface passivation film layer 40, first fine gate 50, second fine gate 60, third polarity doped layer 70, insulating isolation layer 80, and barrier layer 90.

### Detailed Description of the Embodiments

To make the objectives, technical solutions and advantages of the present disclosure clearer, the present disclosure will be further described in detail below in combination with the drawings and embodiments. Embodiments of the embodiments are shown in the drawings, wherein the same or similar reference signs represent the same or similar elements or elements having the same or similar functions throughout. It should be noted that the embodiments described below with reference to the drawings are exemplary, are merely used to explain the present disclosure, but cannot be construed as limiting the present disclosure. In addition, it should be understood that specific embodiments described herein are only used to explain the present disclosure and are not intended to limit the present disclosure.

In the description of the present disclosure, it should be understood that orientation or position relationships indicated by terms "upper", "lower", "left", "right", "transverse", "longitudinal" and a like are orientation or position relationships shown based on the drawings, and are merely for the convenience of describing the present disclosure and simplifying the description, but do not indicate or imply that referred apparatuses or elements must have specific orientations or must be constructed and operated in specific orientations, and thus cannot be construed as limitations to the present disclosure.

In addition, the terms "first", "second" and a like are used for descriptive purposes only and cannot be understood as indicating or implying relative importance or implicitly indicating the number of indicated technical features. Therefore, features defined with "first" and "second" can explicitly or implicitly include one or more of the features. In the description of the present disclosure, "several" means two or more, unless specifically defined otherwise.

In the present disclosure, unless otherwise specified and limited, a first feature being "on" or "under" a second feature can include that the first feature and the second feature are in direct contact with each other, or the first feature and the second feature are in direct contact with each other but are in in contact through an additional feature therebetween. Moreover, the first feature being "over", "above" and "on" the second feature includes that the first feature is directly above or obliquely above the second feature, or merely indicates that a horizontal height of the first feature is greater than a horizontal height of the second feature. The first feature being "under", "below" and "beneath" the second feature includes that the first feature is directly below or obliquely below the second feature, or merely indicates that the horizontal height of the first feature is less than the horizontal height of the second feature.

The following disclosure provides many different embodiments for implementing different structures of the present disclosure. In order to simplify disclosure of the present disclosure, components and settings of specific embodiments are described below. Of course, they are merely embodiments, and are not intended to limit the present disclosure. In addition, the present disclosure can repeat reference numerals and/or reference letters in different embodiments, and this repetition is for a purpose of simplicity and clarity, and does not indicate the relationship between various embodiments and/or settings discussed in itself. In addition, the present disclosure provides embodiments of various particular processes and materials, but those ordinary skilled in the art can be aware of disclosures of other processes and/or use scenarios of other materials.

### Embodiment 1

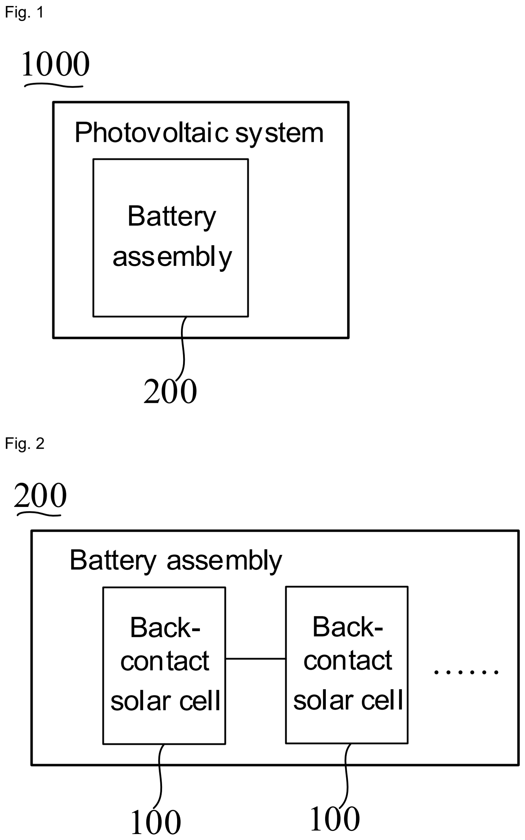

Referring to Fig. 1 and Fig. 2, a photovoltaic system 1000 in the embodiment of the present disclosure can include a battery assembly 200 in the embodiment of the present disclosure, the battery assembly 200 in the embodiment of the present disclosure can include several back-contact solar cells 100 in the embodiment of the present disclosure, and a plurality of back-contact solar cells 100 in the battery assembly 200 can be sequentially connected together in series through a solder strip to form a battery string. The battery strings in the battery assembly 200 can be connected in series, in parallel, or combined in series and in parallel to realize confluence output of current, for example, a connection between the battery strings can be implemented by a bus bar.

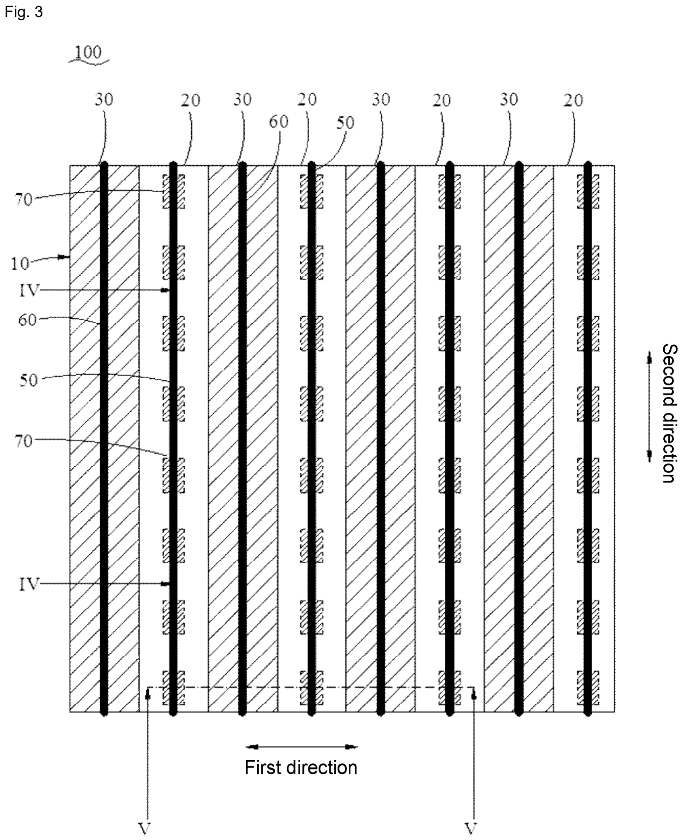

Referring to Fig. 3 to Fig. 5, the back-contact solar cell 100 in the embodiment of the present disclosure can include a silicon substrate 10, several first polarity doped layers 20, several second polarity doped layers 30, back-surface passivation film layers 40, several first fine gates 50, several second fine gates 60, and third polarity doped layers 70.

The several first polarity doped layers 20 and the several second polarity doped layers 30 are disposed on a back surface 11 of the silicon substrate 10 in a stacked manner and are sequentially and alternately arranged at intervals in a first direction, the first polarity doped layers 20 and the second polarity doped layers 30 extend in a second direction, and the second direction intersects with the first direction. Specifically, the first direction and the second direction can be preferably a transverse direction and a longitudinal direction of the back-contact solar cell 100 respectively, which are perpendicular to each other. Of course, in other embodiments, the first direction and the second direction can also directions other than the transverse direction and the longitudinal direction, as long as the two directions intersect with each other, for example, the two directions are respectively diagonal directions of the back-contact solar cell 100, which is not specifically limited herein.

The back-surface passivation film layers 40 are disposed on the first polarity doped layers 20 and the second polarity doped layers 30 in the stacked manner, the first fine gates 50 are correspondingly disposed on the first polarity doped layers 20 and are configured to collecting current of the first polarity doped layers 20, and the second fine gates 60 are correspondingly disposed on the second polarity doped layers 30 and are configured to collecting current of the second polarity doped layers 30. That is, the first fine gates 50 and the second fine gates 60 also extend in the second direction.

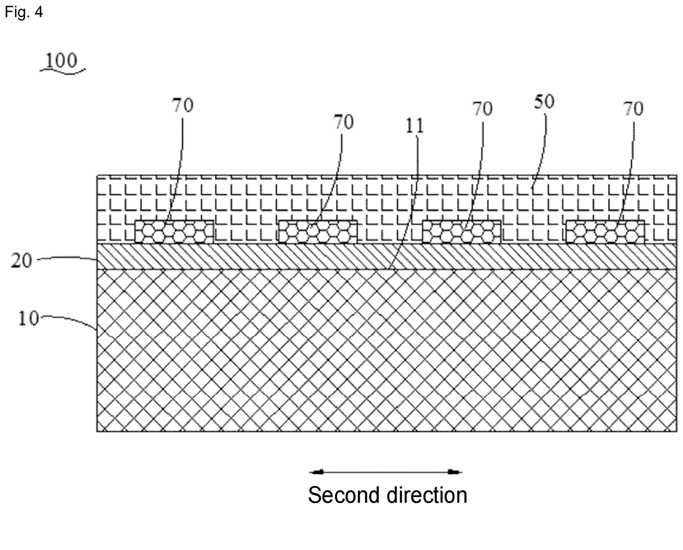

As shown in Fig. 3 and Fig. 4, in the second direction, several third polarity doped layers 70 arranged at intervals are disposed below the first fine gates 50, the third polarity doped layers 70 are located between the back-surface passivation film layers 40 and the first polarity doped layers 20, the first fine gates 50 are made of a burn-through paste, and the polarity of the third polarity doped layers 70 is opposite to that of the first polarity doped layers 20;
in the second direction, at positions corresponding to the third polarity doped layers 70, the first fine gates 50 burn through the back-surface passivation film layers 40 to make contact with the third polarity doped layers 70, between two adjacent third polarity doped layers 70, the first fine gates 50 burn through the back-surface passivation film layers 40 to make contact with the first polarity doped layers 20, and the second fine gates 60 at least partially penetrate through the back-surface passivation film layers 40 to make contact with the second polarity doped layers 30; and
the third polarity doped layers 70 are obtained by partially removing clad layers formed on the first polarity doped layers 20 during the process of forming the second polarity doped layers 30, and etching modes in the prior art such as acid etching, alkali etching and laser etching can be used for the partial removal. (It should be noted that, since Fig. 4 is a cross-sectional view of the first fine gate 50 in the second direction, at this position, the back-surface passivation film layer 40 is substantially completely ablated, therefore the back-surface passivation film layer 40 is not shown in Fig. 3).

In the back-contact solar cell 100, the battery assembly 200 and the photovoltaic system 1000 in the embodiment of the present disclosure, the several first polarity doped layers 20 and the several second polarity doped layers 30, which are sequentially and alternately arranged at intervals in the first direction, are disposed on the back surface 11 of the silicon substrate 10 in the stacked manner, the first polarity doped layers 20 and the second polarity doped layers 30 extend in the second direction, the first fine gates 50 and the first polarity doped layers 20 are correspondingly disposed, the second fine gates 60 and the second polarity doped layers 30 are correspondingly disposed, and the first fine gates 50 are made of the burn-through paste. In the second direction, the several third polarity doped layers 70 arranged at intervals are disposed below the first fine gates 50, the third polarity doped layers 70 are located between the back-surface passivation film layers 40 and the first polarity doped layers 20, at the positions corresponding to the third polarity doped layers 70, the first fine gates 50 burn through the back-surface passivation film layers 40 to make contact with the third polarity doped layers 70, between two adjacent third polarity doped layers 70, the first fine gates 50 burn through the back-surface passivation film layers 40 to make contact with the first polarity doped layers 20, and the second fine gates 60 at least partially penetrate through the back-surface passivation film layers 40 to make contact with the second polarity doped layers 30. In this way, during a process of preparing the first fine gates 50 by using the burn-through paste, the first fine gates 50 will only burn through the back-surface passivation film layers 40 at the intervals between the third polarity doped layers 70 to make contact with the first polarity doped layers 20, and at the positions corresponding to the third polarity doped layers 70, the first fine gates 50 only burn through the back-surface passivation film layers 40 to make contact with the third polarity doped layers 70 without forming direct contact with the first polarity doped layers 20, therefore selective burn-through of the burn-through paste can be realized, a metalized contact area between the first fine gates 50 and the first polarity doped layers 20 can be reduced, the composite current can be reduced, and the efficiency of the back-contact solar cell 100 can be improved.

Meanwhile, since the third polarity doped layers 70 are obtained by partially removing the clad layers formed on the first polarity doped layers 20 during the process of forming the second polarity doped layers 30, it is not necessary to use an additional deposition means to form the third polarity doped layers 70, and it is only necessary to partially remove the clad layers formed on the first polarity doped layers 20, so that processes can be saved.

It is not difficult to understand that in the conventional technical solutions, the first polarity doped layers 20 are first deposited on the entire back surface 11 of the silicon substrate 10, after the first polarity doped layers 20 are formed, a part of the first polarity doped layers 20 is removed by etching or laser grooving to form, on the first polarity doped layers 20, trenches for preparing the second polarity doped layers 30, the second polarity doped layers 30 are then formed on the trenches, and slotting is performed at contact portions of the first polarity doped layers 20 and the second polarity doped layers 30 to realize the isolation between the first polarity doped layers 20 and the second polarity doped layers 30, so as to form the first polarity doped layers 20 and the second polarity doped layers 30, which are sequentially and alternately arranged at intervals.

It can be understood that during a process of preparing the second polarity doped layers 30, clad layers of the third polarity doped layers 70 having the same polarity as the second polarity doped layers 30 are formed on the first polarity doped layers 20, in the conventional technical solutions, the clad layers formed on the first polarity doped layers 20 need to be completely removed, or are not removed and the first fine gates 50 are disposed at positions without the clad layers or the first fine gates 50 directly burn through all the clad layers to make contact with the first polarity doped layers 20; while in the present disclosure, the clad layers are only partially removed, and a part of the clad layers is reserved to form the third polarity doped layers 70, the first fine gates 50 are disclosed above the third polarity doped layers 70 to realize selective burn-through of the paste, so as to realize the local contact between the first fine gates 50 and the first polarity doped layers 20, in this way, it is not necessary to use an additional process to form the third polarity doped layers 70, and thus process procedures can be saved.

In the present disclosure, in some embodiments, the silicon substrate 10 is a P-type silicon substrate , in some embodiments, the silicon substrate 10 is an N-type silicon substrate, in some embodiments, the first polarity doped layer 20 is a P-type doped layer, in some embodiments, the first polarity doped layer 20 is an N-type doped layer, one of the first fine gate 50 and the second fine gate 60 is a P-type thin gate, and the other is an N-type thin gate.

It should be noted that in the present disclosure, the burn-through paste refers to a metal paste with a relatively high burn-through capability, which can be a silver pate, a silver-aluminum paste or other pastes, and can completely burn through the back-surface passivation film layers 40 to enable the first fine gates 50 to make contact with the first polarity doped layers 20 and the third polarity doped layers 70 below the back-surface passivation film layers 40. For example, in one possible embodiment, the content of glass powder in the burn-through paste can be higher than that in a conventional paste, so that the burn-through paste has a higher burn-through capability.

### Embodiment 2

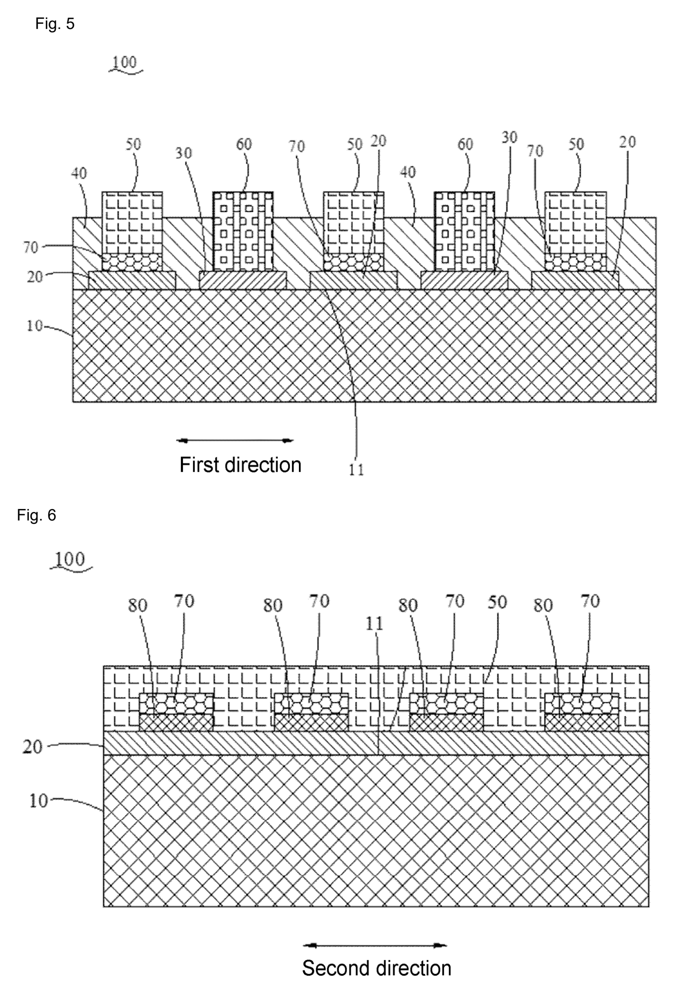

Referring to Fig. 6, in some embodiments, insulating isolation layers 80 are further disposed between the third polarity doped layers 70 and the first polarity doped layers 20, and the insulating isolation layers 80 are also obtained by partially removing the clad layers formed on the first polarity doped layers 20 during the process of forming the second polarity doped layers 30, and etching modes in the prior art such as acid etching, alkali etching and laser etching can be used for the partial removal.

Thus, due to the presence of the insulating isolation layers 80, electric leakage caused by the direct contact between the third polarity doped layers 70 and the first polarity doped layers 20 can be avoided.

In such an embodiment, the insulating isolation layer 80 can include at least one or a combination of more of a borosilicate glass layer, a phosphosilicate glass layer, and a borophosphosilicate glass layer.

Specifically, in the present disclosure, during a process of depositing the second polarity doped layers 30, the clad layers with the third polarity doped layers 70 can be formed on the first polarity doped layers 20. When the first polarity doped layers 20 are P-type doped layers and the second polarity doped layers 30 are N-type doped layers, the clad layers include phosphosilicate glass layers and N-type doped layers (i.e., the third polarity doped layers 70) disposed on the phosphosilicate glass layers in the stacked manner, in this way, the insulating isolation layers 80 and the third polarity doped layers 70 can be obtained just by partially removing the clad layers, the phosphosilicate glass layers are the insulating isolation layers 80, and the N-type doped layers are the third polarity doped layers 70.

When the first polarity doped layers 20 are N-type doped layers and the second polarity doped layers 30 are P-type doped layers, the clad layers include phosphosilicate glass layers and P-type doped layers disposed on the phosphosilicate glass layers in the stacked manner, in this way, the insulating isolation layers 80 and the third polarity doped layers 70 can be obtained just by partially removing the clad layers, the phosphosilicate glass layers are the insulating isolation layers 80, and the P-type doped layers are the third polarity doped layers 70.

Of course, it can be understood that during a process of forming the first polarity doped layers 20, the phosphosilicate glass layers or borosilicate glass layers can be formed on the first polarity doped layers 20, if the phosphosilicate glass layers or the borosilicate glass layers are not removed before the second polarity doped layers are formed, borophosphosilicate glass layers will be formed during the process of forming the second polarity doped layers 30, and in this case, the insulating isolation layers 80 are the borophosphosilicate glass layers.

### Embodiment 3

In some embodiments, in the second direction, a ratio of a contact length between the first fine gate 50 and the first polarity doped layer 20 to a total length of the first fine gate 50 is 30% to 80%.

Thus, by setting the contact length between the first fine gate 50 and the first polarity doped layer 20 within the above ratio range, the metalized contact area can be effectively reduced to reduce recombination and to avoid an excessively large resistance caused by an an excessively small contact area at the same time, that is, the relationship between recombination and resistance can be balanced to improve the efficiency of the back-contact solar cell 100.

Specifically, in such an embodiment, the ratio of the contact length between the first fine gate 50 and the first polarity doped layer 20 to the total length of the first fine gate 50 can be, for example, 30%, 40%, 50%, 60%, 70%, 80%, or any value between 30% and 80%.

Further, in such an embodiment, after careful researches and derivations by inventors of the present disclosure, it has been discovered that in order to improve the conversion efficiency of the back-contact solar cell 100 as much as possible while balancing metallization recombination and resistance to the maximum extent, the ratio of the contact length between the first fine gate 50 and the first polarity doped layer 20 to the total length of the first fine gate 50 can be preferably within the range of 40% to 60%, for example, 40%, 45%, 50%, 55%, 60%, and any value between 40% and 60%.

### Embodiment 4

In some embodiments, in the first direction, a width of the third polarity doped layer 70 is greater than or equal to a width of the first fine gate 50.

Thus, by setting the width of the first polarity doped layer 20 to be greater than or equal to the width of the first fine gate 50, the first fine gate 50 does not make any contact with the first polarity doped layer 20 in a corresponding region of the third polarity doped layer 70, thereby reducing the recombination.

### Embodiment 5

In some embodiments, the first polarity doped layer 20 can be a P-type doped layer, and both the second polarity doped layer 30 and the third polarity doped layer 70 can be N-type doped layers.

Thus, when the third polarity doped layer 70 on the P-type doped layer is an N-type doped layer, by disposing the N-type doped layer on the P-type doped layer, a bonding tensile force between the back-surface passivation film layer 40 and the N-type doped layer is greater than a bonding tensile force between the passivation film layer and the P-type doped layer, therefore when welding spots are subsequently disposed, a welding tensile force of the welding spots during welding can be effectively improved, thereby effectively avoiding the separation of the welding spots during welding, and thus improving the reliability of welding.

### Embodiment 6

In some embodiments, a bonding tensile force between the first fine gate 50 and the third polarity doped layer 70 is greater than a bonding tensile force between the first fine gate 50 and the first polarity doped layer 20.

Thus, by disposing the third polarity doped layer 70, the stability of the first fine gate 50 can be improved, and thus the first fine gate 50 can be effectively prevented from deviating and falling off.

### Embodiment 7

In some embodiments, a bonding tensile force between the third polarity doped layer 70 and the back-surface passivation film layer 40 is greater than a bonding tensile force between the first polarity doped layer 20 and the back-surface passivation film layer 40.

Thus, since the bonding tensile force between the third polarity doped layer 70 and the back-surface passivation film layer 40 is greater, the tensile force of the welding spots disposed on the back-surface passivation film layer 40 can be effectively improved, thereby prevent the welding spots from falling off during welding.

Specifically, in such an embodiment, the first polarity doped layer 20 is the P-type doped layer, the third polarity doped layer 70 is an N-type third polarity doped layer 70, and a bonding tensile force between the N-type doped layer and the back-surface passivation film layer 40 is greater than a tensile force between the P-type doped layer and the back-surface passivation film layer 40.

Further, in such an embodiment, in some embodiments, the back-contact solar cell 100 further includes welding spots (not shown in Fig) connected with the first fine gates 50, and the welding spots are disposed on the back-surface passivation film layers 40 and are at least partially located above the third polarity doped layers 70.

Thus, by at least partially disposing the welding spots above the third polarity doped layers 70, the welding tensile force of the welding spots during welding can be improved.

Further, in some embodiments, the welding spot at least partially burns through the back-surface passivation film layer 40 to make contact with the third polarity doped layer 70, and a bonding tensile force between the welding spot and the third polarity doped layer 70 is greater than a bonding tensile force between the welding spot and the first polarity doped layer 20.

Thus, the bonding tensile force between the welding spot and the third polarity doped layer 70 is greater, and accordingly the welding tensile force of the welding spot during welding can also be effectively improved.

Specifically, in such an embodiment, the welding spot can be a P-type welding spot, and in some embodiments, a paste for forming the welding spot is the same as the paste for forming the first fine gate 50, in some embodiments, a paste for forming the welding spot is different from the paste for forming the first fine gate 50, which is not specifically limited herein.

Further, in some embodiments, a projection area of the third polarity doped layer 70 on the silicon substrate 10 is greater than or equal to a projection area of the welding spot on the silicon substrate 10, and the welding spot is completely located in a projection region of the third polarity doped layer 70.

Thus, since the welding spot is completely located in the region where the third polarity doped layer 70 is located, and the third polarity doped layer 70 is disposed below the entire welding spot, the welding tensile force at the welding spot can be improved to the maximum extent, thereby ensuring the reliability of welding.

Specifically, in such an embodiment, a area of the third polarity doped layer 70 can preferably be exactly equal to the projection area of the welding spot or slightly greater than the projection area of the welding spot, which is not specifically limited herein.

### Embodiment 8

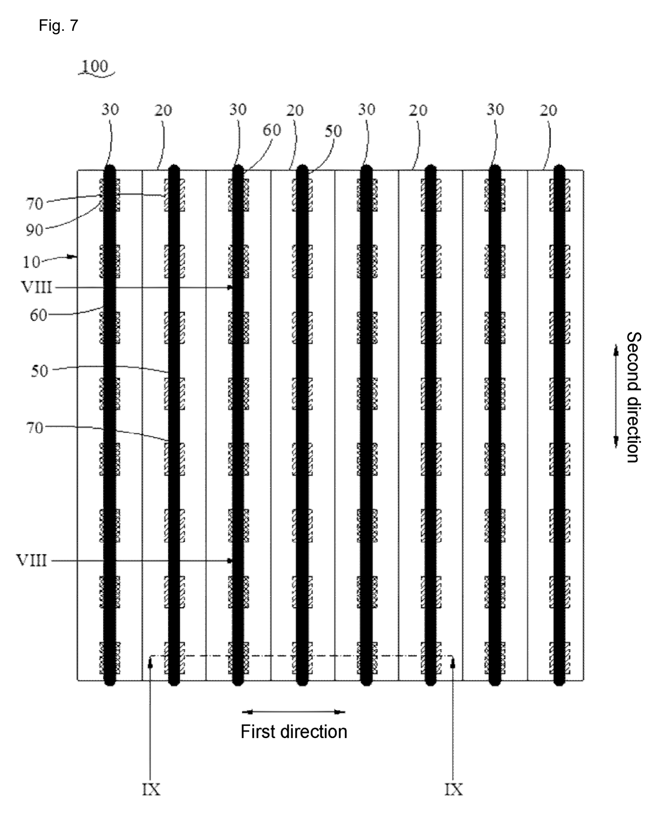

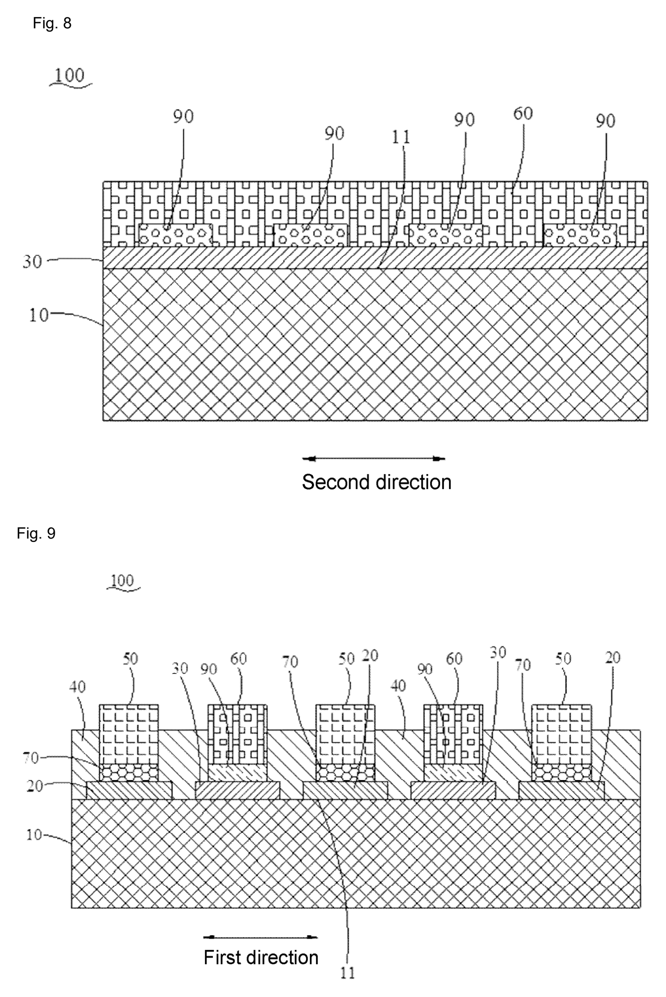

Referring to Fig. 7 to Fig. 9, in some embodiments, in the second direction, at positions corresponding to the second fine gates 60, several barrier layers 90 arranged at intervals are disposed between the second polarity doped layers 30 and the back-surface passivation film layers 40, the second fine gates 60 are also made of the burn-through paste, at positions corresponding to the barrier layers 90, the second fine gates 60 burn through the back-surface passivation film layers 60 to make contact with the barrier layers 90, between two adjacent barrier layers 90, the second fine gates 60 burn through the back-surface passivation film layers 40 to make contact with the second polarity doped layers 30, and the barrier layers 90 include phosphosilicate glass layers or borosilicate glass layers.

Thus, by disposing the barrier layers 90, during a process of preparing the second fine gates 60, the second fine gates 60 partially burn through the back-surface passivation film layers 40 to make contact with the second polarity doped layers 30, and the second fine gates 60 only burn through the back-surface passivation film layers 40 at the barrier layers 90 to make contact with the barrier layers 90 without forming direct contact with the second polarity doped layers 30, in this way, selective burn-through of the burn-through paste can be realized, the metalized contact area between the second fine gates 60 and the second polarity doped layers 30 can be reduced, and the recombination of a metalized region can be reduced, so that the conversion efficiency of the back-contact solar cell 100 is further improved.

Specifically, in such an embodiment, the second polarity doped layers 30 can be formed by deposition or diffusion, and when the second polarity doped layers 30 are N-type doped layers, phosphosilicate glass layers are formed on the second polarity doped layers 30 during the process of forming the second polarity doped layers 30, and in a subsequent removal process, the phosphosilicate glass layers at second occluded regions of the second polarity doped layers 30 are reserved to form the barrier layers 90, that is, the barrier layers 90 are the phosphosilicate glass layers.

When the second polarity doped layers 30 are P-type doped layers, during the process of forming the second polarity doped layers 30, borosilicate glass layers are formed on the second polarity doped layers 30, and in the subsequent removal process, the borosilicate glass layers at the second occluded regions of the second polarity doped layers 30 are reserved to form the barrier layers 90, that is, the barrier layers 90 are the borosilicate glass layers.

In the description of the present specification, description with reference to the terms "some embodiments", "an exemplary embodiment", "an embodiment", "a specific embodiment" or "some embodiments" means that particular features, structures, materials or characteristics described in connection with the embodiment or embodiment are included in at least one embodiment or embodiment of the present disclosure. In the present specification, the schematic representation of the above terms does not necessarily refer to the same embodiment or embodiment. Furthermore, the particular features, structures, materials or characteristics described can be combined in any suitable manner in one or more embodiments or embodiments.

In addition, the above descriptions are merely preferred embodiments of the present disclosure and are not intended to limit the present disclosure, and any modifications, equivalent replacements, improvements, and the like, made within the spirit and principles of the present disclosure, shall fall within the protection scope of the present disclosure.

## Claims

1. A back-contact solar cell, comprising:
a silicon substrate;
several first polarity doped layers and several second polarity doped layers, which are disposed on a back surface of the silicon substrate in a stacked manner, wherein the first polarity doped layer and the second polarity doped layer are sequentially and alternately arranged at intervals in a first direction and extend in a second direction, and the second direction intersects with the first direction;
back-surface passivation film layers, which are disposed on the first polarity doped layers and the second polarity doped layers in the stacked manner; and
several first fine gates and several second fine gates, wherein the first fine gates are correspondingly disposed on the first polarity doped layers and are configured to collecting current of the first polarity doped layers, and the second fine gates are correspondingly disposed on the second polarity doped layers and are configured to collecting current of the second polarity doped layers;
in the second direction, several third polarity doped layers arranged at intervals are disposed below the first fine gates, the third polarity doped layers are located between the back-surface passivation film layers and the first polarity doped layers, the first fine gates are made of a burn-through paste, and a polarity of the third polarity doped layers is opposite to a polarity of the first polarity doped layers;
in the second direction, at positions corresponding to the third polarity doped layers, the first fine gates burn through the back-surface passivation film layers to make contact with the third polarity doped layers, between two adjacent third polarity doped layers, the first fine gates burn through the back-surface passivation film layers to make contact with the first polarity doped layers, and
the second fine gates at least partially penetrate through the back-surface passivation film layers to make contact with the second polarity doped layers; and
the third polarity doped layers are obtained by partially removing clad layers formed on the first polarity doped layers during a process of forming the second polarity doped layers.

2. The back-contact solar cell according to claim 1, wherein in the second direction, a ratio of a contact length between the first fine gate and the first polarity doped layer to a total length of the first fine gate is 30% to 80%.

3. The back-contact solar cell according to claim 2, wherein in the second direction, the ratio of the contact length between the first fine gate and the first polarity doped layer to the total length of the first fine gate is 40% to 60%.

4. The back-contact solar cell according to claim 1, wherein insulating isolation layers are further disposed between the third polarity doped layers and the first polarity doped layers, and the insulating isolation layers are also obtained by partially removing the clad layers formed on the first polarity doped layers during the process of forming the second polarity doped layers.

5. The back-contact solar cell according to claim 1, wherein in the first direction, a width of the third polarity doped layer is greater than or equal to a width of the first fine gate.

6. The back-contact solar cell according to claim 1, wherein the first polarity doped layer is a P-type doped layer, and the second polarity doped layer and the third polarity doped layer are both N-type doped layers.

7. The back-contact solar cell according to claim 6, wherein a bonding tensile force between the third polarity doped layer and the back-surface passivation film layer is greater than a bonding tensile force between the first polarity doped layer and the back-surface passivation film layer.

8. The back-contact solar cell according to claim 7, wherein the back-contact solar cell further comprises welding spots electrically connected with the first fine gates, and the welding spots are disposed on the back-surface passivation film layers and are at least partially located above the third polarity doped layers.

9. The back-contact solar cell according to claim 8, wherein a projection area of the third polarity doped layer on the silicon substrate is greater than or equal to a projection area of the welding spot on the silicon substrate, and the welding spot is completely located in a projection region of the third polarity doped layer.

10. The back-contact solar cell according to claim 1, wherein in the second direction, at positions corresponding to the second fine gates, several barrier layers arranged at intervals are disposed between the second polarity doped layers and the back-surface passivation film layers, and the second fine gates are also made of the burn-through paste; and
at positions corresponding to the barrier layers, the second fine gates burn through the back-surface passivation film layers to make contact with the barrier layers, between two adjacent barrier layers, the second fine gates burn through the back-surface passivation film layers to make contact with the second polarity doped layers, and the barrier layers comprise phosphosilicate glass layers or borosilicate glass layers.

11. A battery assembly, comprising several back-contact solar cells according to any of claims 1-10.

12. A photovoltaic system, comprising the battery assembly according to claim 11.
